# EUROPEAN PATENT APPLICATION

(11) **EP 2 515 348 A1**
(43) Date of publication of application: **24.10.2012**
(21) Application number: 12466008.5
(22) Date of filing: 20.04.2012
(51) Int. Cl.: H01L 31/042, H01L 31/052, F24J 2/46, B08B 3/02

(54) **Mechanical device for increasing the power of photovoltaic panels**

(30) Priority: 21.04.2011 CZ 201124243 U
(71) Applicant: Helios Tech., a.s., 11000 Praha 1 (CZ); Kasikova, Gabriela, 415 01 Teplice (CZ)
(72) Inventor: Kasikova, Gabriela, 41501 Teplice (CZ); Somolik, Ladislav, 33011 Tremosna (CZ)
(74) Representative: Langrova, Irena

(57) **Abstract**

Mechanical device for increasing the power of photovoltaic panels enables the panels to be cleaned and cooled automatically by that it uses a movable appliance on the panel surface. The device is based on a light travelling structure which bears a wiping lath and moves horizontally by means of guide rollers on the top edge of panels. The proper movement in both directions is caused by means of a rope sling driven with a reversible electric drive. The wiping lath changes the angle of engagement in dependence on the direction of movement due to which the wiping efficiency is augmented - that of carrying away of impurities on an inclined plane in both movement directions.

## Description

### Field of Engineering

The technical device refers to photovoltaic panels for production of the electrical energy and enables to increase the power thereof. Therefore, the field of technics is the energetic engineering.

### State of the Prior Art

With the practical experience growing in operating the solar power plants, various views increase on the existence of some negative influences which reduce demonstrably the effectivity of these devices. It is simple to designate them altogether:
1. Deposition of flying dust from industrial emissions, motor cars traffic, and from chimneys of local solid fuel heaters etc.
2. Sedimentation of pollen of agricultural products in the season of spring when the UV-radiation intensity grows up to auspicious values.
3. Blocking by snow in the winter season - it interrupts the production nearly perfectly.
4. A paradox negative influence is overheating of panels with great power output in connection with high surrounding temperature which means the effectivity drop. The object of the utility model registration is to solve an automatic system for solar panels surface to be cleaned from undesirable sediments of dust, pollen and snow.

Therefore, the task of the technical device is to create better conditions to ensur optimal power of photovoltaic panels.

### Substance of the Technical Solution

The device is based on a light travelling structure which bears a wiping lath and moves horizontally by means of guide rollers on the top edge of panels. The proper movement in both directions is caused by means of a rope sling driven with a reversible electric drive. The wiping lath changes the angle of engagement in dependence on the direction of movement due to which the wiping efficiency is augmented - that of carrying away of impurities on an inclined plane in both movement directions.

The object of the industrial model registration is to solve an automatic cleaning system for solar panels surface from undesirable sediments of dust, pollen and snow inclusive of cooling by means of controlled water rinsing with partially closed water system.

### Examples on Technical Realization

The photovoltaic engineering passes a great boom. Taking in the consideration that the matter is a new appliance yet, the power of panels declares the parameters warranted by the maker. It is well known generally that this power decreases due to many circumstances (as described in the introduction) with the total parameters being influenced by it significantly.

Our idea is based on optimal utilization of solar panels. We design a device which can eliminate the negative influences. At minimum operating costs this device can maintain the solar panels in clean condition and optimize the power thereof. The prevailing maintenance of panels is mechanical one only and coherent with minimum work. At present this means that the operators of these appliances hire a labour which clean the panels from impurities and from snow in winer months.

The proposed device is automatized completely. By means of a rain sensor it gives instructions for a drive unit to operate. On the basis of this signal the said unit starts the cleaning device which starts to clean the panels in horizontal movement by means of a wiper, located between the bearing frame. A great advantage is that the rain (humidity) sensor starts the movement for wiping snow in winter months. In summer months in every rainy day the solar panel is cleaned automatically. This means that the solar panels, maintained in this way, increase their service life (they do not get blind) besides their power.

By paradox, another factor of decreasing power of panels is high temperature originating on the panel due to the sun and ambient temperature. The device can cool the panel down by means of a closed water circuit. In practice this means that a pump delivers water from a tank (or another source) into the top part of the device from which water flows through nozzles over the panels with cooling them down. Subsequently, water flows down into the original source and this circulation goes on further.

## Claims

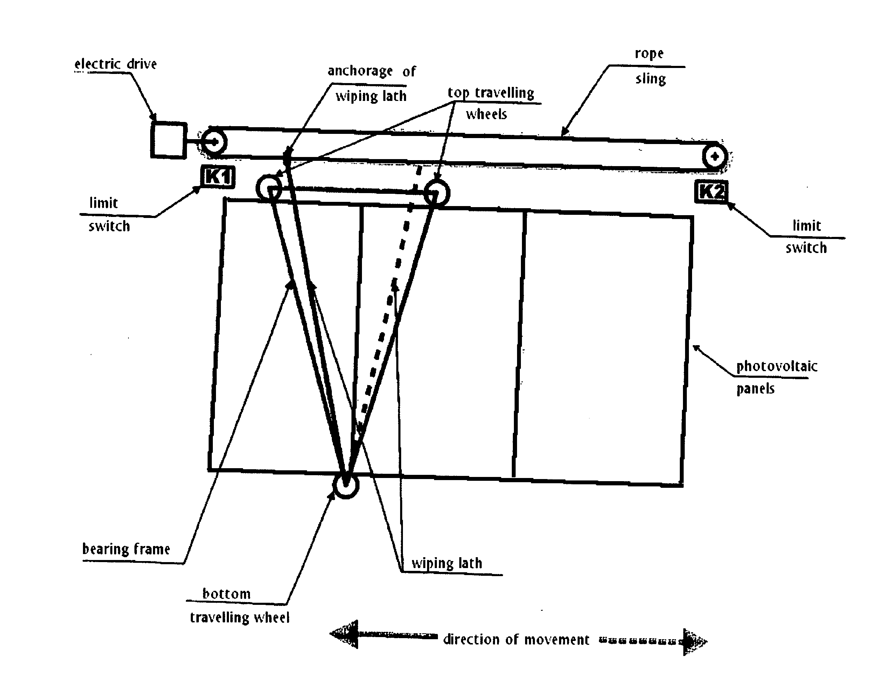

1. Mechanical device for increasing the power of photovoltaic panels, **characterized in that** it enables the panels to be cleaned and cooled automatically by that it uses a movable appliance on the panel surface, said appliance enabling collection of impurities, rinsing and cooling (Fig. 1), by means of a closed water circuit by making use of pumps, controlled with termal sensors, and nozzles in the top part of a panel array, with returning circulation into the original water source.
